# EUROPEAN PATENT APPLICATION

(11) **EP 3 640 721 A1**
(43) Date of publication of application: **22.04.2020**
(21) Application number: 19202954.4
(22) Date of filing: 14.10.2019
(51) Int. Cl.: G02F 1/1335

(54) **BACKLIGHT UNIT AND DISPLAY DEVICE INCLUDING THE SAME**

(30) Priority: 15.10.2018 KR 20180122753
(71) Applicant: Samsung Display Co., Ltd., Gyeonggi-do 17113 (KR)
(72) Inventor: LEE, Jeena, 14038 Gyeonggi-do (KR); JUNG, Sangwoon, 13540 Gyeonggi-do (KR)
(74) Representative: Walaski, Jan Filip

(57) **Abstract**

A display device includes: a light guide plate having upper and lower opposed surfaces, the light guide plate including: a first portion having a side surface; and an second portion extending from the first portion along a first direction; a display panel disposed on the upper surface of the light guide plate; light guide patterns disposed on the lower surface; a first light source facing the side surface in the first direction; and a second light source facing the lower surface in a second direction intersecting the first direction.

## Description

Exemplary implementations of the invention relate generally to a backlight unit and a display device including the same, and more particularly, to a backlight unit and a display device including the same capable of local dimming and enhanced luminance.

### Discussion of the Background

Liquid crystal display ("LCD") devices are one of the most widely used types of flat panel display ("FPD") devices. Such an LCD device includes two substrates on which electrodes are formed and a liquid crystal layer therebetween.

An LCD device is a display device that adjusts the amount of transmitted light by applying voltage to the two electrodes and rearranging liquid crystal molecules of the liquid crystal layer. Accordingly, the LCD device needs a backlight unit for providing light.

A light from the backlight unit passes through, for example, a polarizing plate, a liquid crystal layer, and a colour filter of the LCD device, and in such a case, most of the light is lost by reflection or absorption. Generally, only about 3 % to 10 % of the light emitted from the backlight unit is used to display image.

The above information is only for understanding of the background of the inventive concepts, and, therefore, it may contain information that does not constitute prior art.

### SUMMARY

Backlight units and display devices including the same constructed according to the principles and exemplary implementations of the invention are capable of localized dimming and enhancing luminance.

Additional features of the inventive concepts will be set forth in the description which follows, and in part will be apparent from the description, or may be learned by practice of the inventive concepts.

According to one or more embodiments of the invention, a backlight unit for a display panel includes: a light guide plate having opposite upper and lower surfaces, the light guide plate including: a first portion having a side surface; and a second portion extending from the first portion along a first direction; a display panel disposed on the upper surface of the light guide plate; light guide patterns disposed on the lower surface; a first light source facing the side surface in the first direction; and a second light source facing the lower surface in a second direction intersecting the first direction.

The backlight unit may further include: a scattering layer disposed on an upper surface of at least a part of the second portion.

The backlight unit may further include a colour conversion layer disposed on an upper surface of at least a part of the second portion.

Pitch between the light guide patterns may gradually decrease along a direction farther away from the first light source.

The backlight unit may further include a bottom case housing the light guide plate, the first light source, and the second light source.

The bottom case may include: a first base portion facing the lower surface of the first portion with the light guide patterns interposed therebetween; a second base portion facing the lower surface of the first portion with the light guide patterns interposed therebetween, the second base portion disposed closer to the light guide plate than the first base portion; and a third base portion facing the lower surface of the second portion with the second light source interposed therebetween, the third base portion disposed farther away from the light guide plate than the first base portion is therefrom.

The bottom case may include: a first connection portion connecting the first base portion and the second base portion; and a second connection portion connecting the second base portion and the third base portion.

The second base portion may have a recess depressed toward the first portion.

The backlight unit may further include a printed circuit board disposed at the recess and connected to the display panel.

The backlight unit may further include a protection case including a protective portion that faces the second base portion with the printed circuit board interposed therebetween.

A distance from an upper surface of the light guide plate to an outer surface of the third base portion may be substantially equal to a distance from the upper surface of the light guide plate to an outer surface of the protective portion.

The backlight unit may further include a lens enclosing the second light source.

The backlight unit may further include a third light source facing another side surface of the first portion in a third direction, the third direction intersecting the first direction and the second direction.

The first portion may include a light guide portion and the second portion includes an extension portion, the light guide portion including: a first light guide portion; and a second light guide portion extending from the first light guide portion along the first direction, wherein the second light guide portion may include: a first inclined surface and a second inclined surface inclined at respective angles in the second direction to form a triangular cross-section, wherein the light guide patterns may be disposed on the first inclined surface of the second light guide portion.

The second light source may include: a first dimming light source including a light emission surface facing the second inclined surface; and a second dimming light source including a light emission surface facing the lower surface corresponding to the extension portion.

The light guide patterns may be disposed on the lower surface corresponding to the first inclined surface, and wherein pitch between the light guide patterns may gradually decrease along a direction farther away from the first dimming light source.

The backlight unit may further include a bottom case including: a first base portion facing a lower surface of the first light guide portion; a second base portion facing the first inclined surface of the second light guide portion with the light guide patterns interposed therebetween; and a third base portion facing the lower surface of the extension portion with the second light source interposed therebetween, wherein the light guide plate, the first light source, and the second light source may be housed in the bottom case.

The angle between the second inclined surface and the lower surface of the extension portion may be an obtuse angle.

The first portion may include a light guide portion and the second portion includes an extension portion, wherein a thickness of the light guide portion may gradually decrease along a direction farther away from the first light source to form an inclined surface, and wherein the light guide patterns may be disposed on the inclined surface.

The backlight unit may further include a bottom case including: a first base portion facing the inclined surface of the first portion with the light guide patterns interposed therebetween; and a second base portion facing the lower surface of the second portion with the second light source interposed therebetween, wherein the light guide plate, the first light source, and the second light source may be disposed on the bottom case.

The light guide plate may include dimming areas, and wherein the backlight unit may be configured to: control the first light source to individually adjust the luminance of the dimming areas overlapping the first portion of the light guide plate; and control the second light source to individually adjust the luminance of the dimming areas overlapping the second portion of the light guide plate.

According to one or more embodiments of the invention, there is provided a backlight unit for a display panel, the backlight unit including: a light guide plate having opposite upper and lower surfaces, and dimming areas, the light guide plate including: a first portion having a side surface; and a second portion extending from the first portion along a first direction; light guide patterns disposed on the lower surface; a first light source facing the side surface of the first portion in the first direction; and a second light source facing the lower surface in a second direction intersecting the first direction, and wherein the backlight unit may be configured to: control the first light source to individually adjust the luminance of the dimming areas overlapping the first portion of the light guide plate; and control the second light source to individually adjust the luminance of the dimming areas overlapping the second portion of the light guide plate.

The backlight unit may further include a bottom case including: a first base portion facing the lower surface with the light guide patterns interposed therebetween; a second base portion facing the lower surface with the light guide patterns interposed therebetween, the second base portion disposed closer to the light guide plate than the first base portion; and a third base portion facing the lower surface with the second light source interposed therebetween, the third base portion disposed farther away from the light guide plate than the first base portion is therefrom, wherein the light guide plate, the first light source, and the second light source may be housed in the bottom case.

The first portion may include a light guide portion and the second portion includes an extension portion, the light guide portion including: a first light guide portion; and a second light guide portion extending from the first light guide portion along the first direction, wherein the second light guide portion may include: a first inclined surface and a second inclined surface inclined at respective angles in the second direction to form a triangular cross-section, wherein the light guide patterns may be disposed on the first inclined surface of the second light guide portion, wherein the second light source may include: a first dimming light source including a light emission surface facing the second inclined surface; and a second dimming light source including a light emission surface facing the lower surface corresponding to the extension portion, wherein the light guide patterns may be disposed on the lower surface corresponding to the first inclined surface, and wherein pitch between the light guide patterns may gradually decrease along a direction farther away from the first dimming light source.

A thickness of the light guide plate may gradually decrease along a direction farther away from the first light source to form an inclined surface, and wherein the light guide patterns may be disposed on the inclined surface.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate exemplary embodiments of the invention, and together with the description serve to explain the inventive concepts.
FIG. 1 is an exploded perspective view of a display device constructed according to an exemplary embodiment.
FIG. 2 is a cross-sectional view taken along sectional line I-I' in FIG. 1.
FIG. 3 is an enlarged view of a peripheral portion of an exemplary embodiment of the light guide plate of FIG. 2.
FIG. 4 is an enlarged view of a peripheral portion of another exemplary embodiment of the light guide plate of FIG. 2.
FIG. 5 is a plan view illustrating the light guide plate, first light source module, and second light source module of FIG. 2.
FIG. 6 is a cross-sectional view taken along sectional line I-I' in FIG. 1 according to another exemplary embodiment.
FIG. 7 is a cross-sectional view taken along sectional line I-I' in FIG. 1 according to another exemplary embodiment.
FIG. 8 is an enlarged view of a peripheral portion of an exemplary embodiment of the light guide plate of FIG. 7.
FIG. 9 is a cross-sectional view taken along sectional line I-I' in FIG. 1 according to another exemplary embodiment.
FIG. 10 is an enlarged view of a peripheral portion of an exemplary embodiment of the light guide plate of FIG. 9.
FIG. 11 is a plan view illustrating a light guide plate, a first light source module, and a second light source module of FIG. 2 according to another exemplary embodiment.

### DETAILED DESCRIPTION

In the following description, for the purposes of explanation, numerous specific details are set forth in order to provide a thorough understanding of various exemplary embodiments or implementations of the invention. As used herein "embodiments" and "implementations" are interchangeable words that are non-limiting examples of devices or methods employing one or more of the inventive concepts disclosed herein. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an exemplary embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on", "connected to", or "coupled to" another element or layer, it may be directly on, connected to, or coupled to the other element or layer or intervening elements or layers may be present. When, however, an element or layer is referred to as being "directly on", "directly connected to" or "directly coupled to" another element or layer, there are no intervening elements or layers present. To this end, the term "connected" may refer to physical, electrical, and/or fluid connection, with or without intervening elements. Further, an X-axis, the an Y-axis, and the a Z-axis are not limited to three axes of a rectangular coordinate system, such as the x, y, and z - axes, and may be interpreted in a broader sense. For example, the X-axis, the Y-axis, and the Z-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first", "second", etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below", "under", "lower", "above", "upper", "over", "higher", "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a", "an", and "the" are intended to include the plural forms as well, unless the context clearly indicates otherwise. Moreover, the terms "comprises", "comprising", "includes" and/or "including" when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially", "about" and other similar terms, are used as terms of approximation and not as terms of degree, and, as such, are utilized to account for inherent deviations in measured, calculated, and/or provided values that would be recognized by one of ordinary skill in the art.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, ± 20%, ± 10%, ± 5% of the stated value.

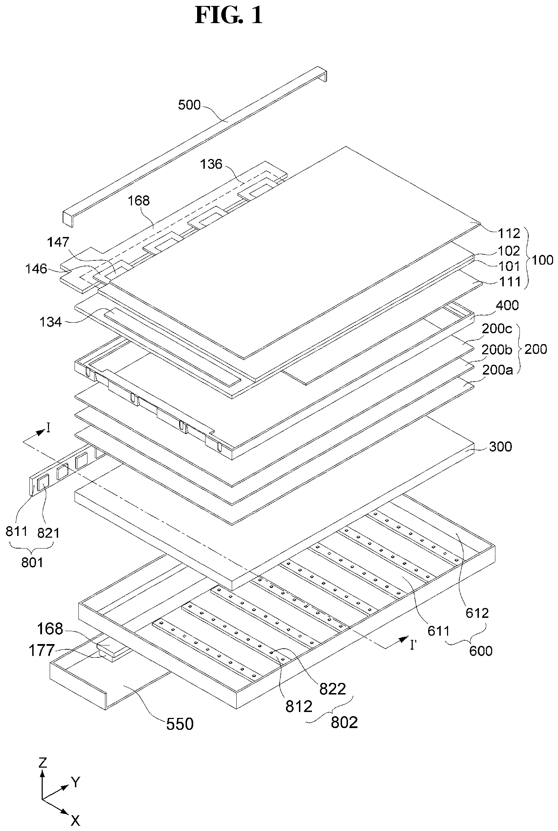

Hereinafter, backlight units and display devices including the same according to exemplary embodiments will be described in detail with reference to FIGS. 1, 2, 3, 4, 5, 6, 7, 8, 9, 10, and 11.

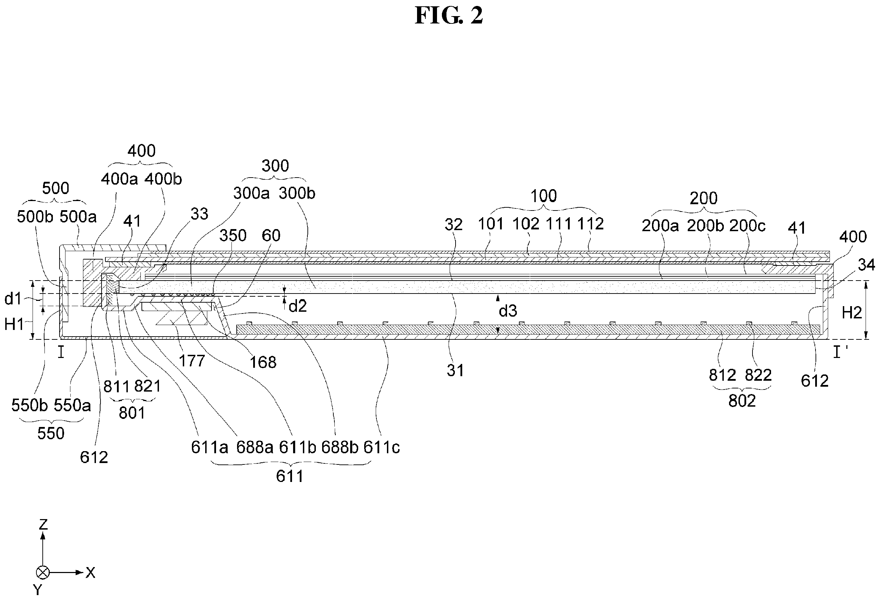

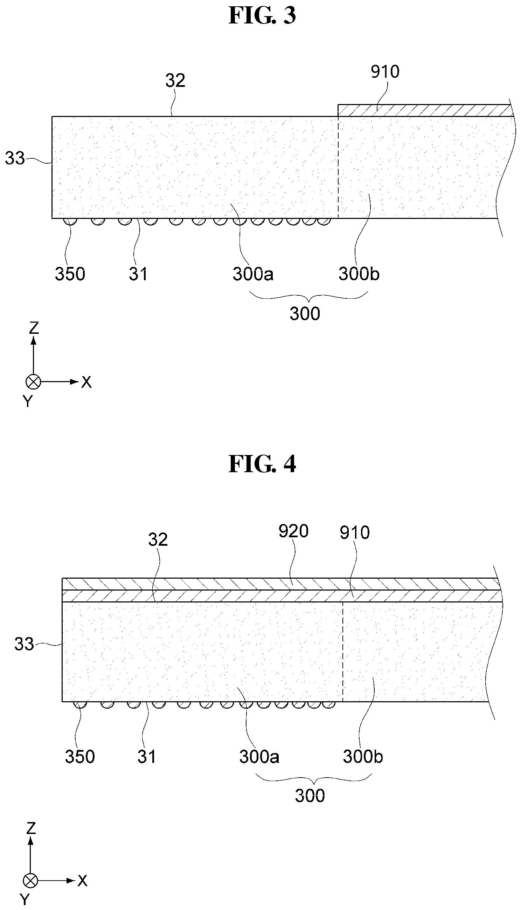

FIG. 1 is an exploded perspective view illustrating a display device constructed according to an exemplary embodiment, FIG. 2 is a cross-sectional view taken along sectional line I-I' in FIG. 1, and FIG. 3 is an enlarged view of a peripheral portion of an exemplary embodiment of the light guide plate 300 of FIG. 2.

As illustrated in FIGS. 1 and 2, a display device according to an exemplary embodiment includes a first light source module 801, a second light source module 802, a bottom case 600, a light guide plate 300, a light guide pattern 350, an optical film 200, a support frame 400, a display panel 100, a printed circuit board ("PCB") 168, a driving circuit unit 177, a protection case 550, and a top case 500.

Herein, the light guide plate 300, the optical film 200, the first light source module 801, the second light source module 802, and the support frame 400 may be included in a backlight unit. In an exemplary embodiment, the display panel 100 and the backlight unit are assembled in a laminated state to constitute a display module. The display module may further include the top case 500, the bottom case 600, the protection case 550, and the PCB 168.

The light guide plate 300 is positioned inside the bottom case 600. The light guide plate 300 includes a light guide portion 300a and an extension portion 300b, as illustrated in FIGS. 2 and 3. The extension portion 300b extends from the light guide portion 300a along an X-axis direction. The light guide portion 300a and the extension portion 300b are integrally formed into a unitary structure.

A length of the extension portion 300b may be longer than a length of the light guide portion 300a. As used herein, the length of the extension portion 300b and the length of the light guide portion 300a each refer to lengths thereof in the X-axis direction.

A thickness of the extension portion 300b may be substantially equal to a thickness of the light guide portion 300a. In such an exemplary embodiment, the thickness of the extension portion 300b and the thickness of the light guide portion 300a each refer to thicknesses thereof in a Z-axis direction.

Two of the opposing surfaces of the light guide plate 300 respectively facing in the Z-axis direction are defined as a lower surface 31 and an upper surface 32 of the light guide plate 300, and two of the opposing surfaces of the light guide plate 300 respectively facing in the X-axis direction are defined as a first side surface 33 and a second side surface 34 of the light guide plate 300. The lower surface 31 of the light guide plate 300 is farther away from the display panel 100 than the upper surface 32, and the first side surface 33 of the light guide plate 300 is closer to the first light source module 801 than the second side surface 34.

The lower surface 31 of the light guide plate 300 includes the lower surface 31 of the light guide portion 300a and the lower surface 31 of the extension portion 300b.

The upper surface 32 of the light guide plate 300 includes the upper surface 32 of the light guide portion 300a and the upper surface 32 of the extension portion 300b.

As illustrated in FIGS. 1, 2, and 3, at least one light guide pattern 350 is disposed at the light guide portion 300a of the light guide plate 300. For example, a plurality of light guide patterns 350 are disposed at the lower surface 31 of the light guide portion 300a. The light guide patterns 350 may be disposed along the X-axis direction and a Y-axis direction.

The pitch (or interval spacing) between the light guide patterns 350 arranged in the X-axis direction may gradually decrease along a direction (e.g., the X-axis direction) farther away from the first light source module 801 (or a first light source 821 of the first light source module 801). In another exemplary embodiment, however, the light guide patterns 350 may be arranged at regular intervals. The light guide patterns 350 are disposed between first and second base portions 611a and 611b of the bottom case 600 and the light guide portion 300a of the light guide plate 300.

The light guide plate 300 may include a material having transmittance, e.g., an acrylic resin, such as polymethyl methacrylate (PMMA), and polycarbonate (PC), to guide light efficiently.

In an exemplary embodiment, as illustrated in FIG. 3, a scattering layer 910 may be further disposed on the upper surface 32 of the extension portion 300b. Specifically, the scattering layer 910 may be disposed between the extension portion 300b and the optical film 200. The scattering layer 910 may overlap substantially the entirety of the upper surface 32 of the extension portion 300b. The scattering layer 910 scatters light incident upon the extension portion 300b and directs the scattered light toward the display panel 100.

The bottom case 600 has an open space to house certain components therein. The first light source module 801, the second light source module 802, the light guide plate 300, and the optical film 200 are disposed in the open space.

In order to form the open space, the bottom case 600 may include a housing portion 611 and a plurality of side portions 612. For example, the housing portion 611 may have a quadrangular shape, and the side portions 612 protrude from respective edge portions of the housing portion 611 to have a predetermined height. For example, the side portions 612 may protrude from the respective edges of the housing portion 611 along the Z-axis direction. As a specific example, each of the side portions 612 may protrude from the respective edges of the housing portion 611 toward the top case 500. A space defined by the side portions 612 and the housing portion 611 may be defined as the open space. The housing portion 611 and the side portions 612 may be integrally formed into a unitary structure. Edges of adjacent ones of the side portions 612 may be connected to each other.

Two side portions facing each other with the first light source module 801 therebetween (e.g., side portions 612 facing each other in the X-axis direction in FIG. 2) may have lengths different from each other. For example, a side portion (hereinafter, "a first side portion") of the two opposing side portions that is closer to the light guide portion 300a of the light guide plate 300 may have a length shorter than a length of the other side portion (hereinafter, "a second side portion") of the two facing side portions 612. As used herein, the respective lengths of the first and second side portions refer to lengths thereof in the Z-axis direction.

As illustrated in FIG. 2, the housing portion 611 of the bottom case 600 may include a first base portion 611a, a second base portion 611b, a third base portion 611c, a first connection portion 688a, and a second connection portion 688b. The first side portion protrudes from an edge of the first base portion 611a, and the second side portion protrudes from an edge of the third base portion 611c.

The first base portion 611a, the second base portion 611b, and the third base portion 611c are disposed along the X-axis direction. The first base portion 611a and the second base portion 611b are located below the light guide plate 300 so as to face or overlap the light guide portion 300a, and the third base portion 611c is located below the light guide plate 300 to face or overlap the extension portion 300b.

The first base portion 611a, the second base portion 611b, and the third base portion 611c are located at different distances from the light guide plate 300. As used herein, the distance between the light guide plate 300 and corresponding one of the base portions 611a, 611b and 611c refers to a distance in the Z-axis direction. For example, when a distance in the Z-axis direction between the light guide plate 300 and the first base portion 611a is defined as a first distance d1, a distance in the Z-axis direction between the light guide plate 300 and the second base portion 611b is defined as a second distance d2, and a distance in the Z-axis direction between the light guide plate 300 and the third base portion 611c is defined as a third distance d3, the first, second, and third distances are different from each other. In specific, the first distance d1 is greater than the second distance d2 and less than the third distance d3 (d2<d1<d3).

In other words, when the upper surface 32 of the light guide plate 300 is defined as a reference surface, respective outer surfaces of the first, second, and third base portions 611a, 611b, and 611c are located at different heights from the reference surface. As used herein, the outer surface of corresponding one of the base portions 611a, 611b and 611c refers to a surface thereof positioned on the opposite side of an inner surface thereof that faces the light guide plate 300, and the height of corresponding one of the base portions 611a, 611b and 611c refers to a distance in the Z-axis direction from the reference surface to the outer surface thereof. Of the respective outer surfaces of the first, second, and third base portions 611a, 611b, and 611c, the outer surface of the second base portion 611b is located at a lowest height. That is, the outer surface of the second base portion 611b has a shape depressed toward the light guide plate 300. Accordingly, a recess 60 is defined at the outer surface of the second base portion 611b.

Thicknesses of the first base portion 611a, the second base portion 611b, and the third base portion 611c may be substantially the same as each other. As used herein, the thickness of each of the base portions 611a, 611b, and 611c refers to a size thereof in the Z-axis direction.

The first connection portion 688a connects the first base portion 611a and the second base portion 611b, which are located at different distances from the light guide plate 300, to each other. The first connection portion 688a has an obliquely inclined shape. For example, the first connection portion 688a may have a shape inclined at a predetermined angle with respect to the second base portion 611b.

The second connection portion 688b connects the second base portion 611b and the third base portion 611c, which are located at different distances from the light guide plate 300, to each other. The second connection portion 688b has an obliquely inclined shape. For example, the second connection portion 688b may have a shape inclined at a predetermined angle with respect to the second base portion 611b.

The first base portion 611a, the second base portion 611b, the third base portion 611c, the first connection portion 688a, and the second connection portion 688b may be integrally formed into a unitary structure.

The distance d1 between the light guide plate 300 and the first base portion 611a may be substantially the same as the distance d2 between the light guide plate 300 and the second base portion 611b. In other words, the first distance d1 and the second distance d2 may be substantially equal to each other. In such an exemplary embodiment, the first connection portion 688a may be omitted.

The PCB 168 is disposed on the outer surface of the second base portion 611b. The driving circuit unit 177 for driving the display panel 100 is disposed at the PCB 168. Accordingly, the second base portion 611b may be disposed between the PCB 168 and the light guide plate 300.

The first light source module 801 is disposed between the first side portion of the bottom case 600 and the light guide plate 300. The first light source module 801 may include at least one first light source 821 and a first light source circuit board 811.

A light emission surface of the first light source 821 faces the first side surface 33 of the light guide plate 300. The first light source 821 generates light. For example, the first light source 821 may emit a white light or a blue light.

When the first light source 821 is a light source that emits a white light, the first light source 821 may include, for example, a blue light emitting diode ("LED") that emits a blue light and a phosphor surrounding the blue LED. The blue light from the blue LED may be converted into a white light while passing through the phosphor.

As another example, when the first light source 821 is a light source emitting a white light, the light source may include a red LED emitting a red light, a green LED emitting a green light, and a blue LED emitting a blue light. The red light from the red LED, the green light from the green LED, and the blue light from the blue LED may be mixed with each other to generate a white light.

When the first light source 821 is a light source emitting a blue light, the first light source 821 may include a blue LED.

When the first light source module 801 includes the plurality of first light sources 821, the plurality of first light sources 821 are disposed along the first side surface 33 of the light guide plate 300. For example, the plurality of first light sources 821 is disposed along the Y-axis direction, facing the first side surface 33 of the light guide plate 300.

One surface of the first light source circuit board 811 may be divided into at least one mounting area and a wiring area. When the first light source module 801 includes the plurality of first light sources 821, one first light source 821 is disposed at each of the mounting areas, and a plurality of signal lines for transmitting a driving power to the first light sources 821 are disposed at the wiring area. The driving power is generated at an external power supplier, and then applied to the plurality of signal lines through a separate connector. The power supplier may be included in the driving circuit unit 177.

The light from the first light source 821 is incident to the first side surface 33 of the light guide portion 300a of the light guide plate 300. A light incident to the first side surface 33 is substantially totally reflected by the light guide pattern 350 and proceeds to the inside of the light guide portion 300a. The light guide portion 300a substantially totally reflects the light therein and guides the light toward a display area of the display panel 100. In such an exemplary embodiment, the light incident upon the first side surface 33 is substantially totally reflected in the light guide portion 300a by the light guide pattern 350, and is not substantially incident to the extension portion 300b. That is, since the light guide pattern 350 is not disposed at the extension portion 300b, the light from the light guide portion 300a is hardly incident to the extension portion 300b. Accordingly, the light from the light guide portion 300a does not affect luminance of the light that passes through the extension portion 300b, which includes a dimming area as described subsequently.

The second light source module 802 is disposed between the third base portion 611c of the bottom case 600 and the light guide plate 300. As a specific example, the second light source module 802 is disposed between the third base portion 611c and the extension portion 300b of the light guide plate 300. The second light source module 802 may include at least one second light source 822 and a second light source circuit board 812.

A light emission surface of the second light source 822 faces the lower surface 31 of the light guide plate 300. The second light source 822 generates light. For example, the second light source 822 may emit a white light or a blue light. The second light source 822 and the second light source circuit board 812 may have structures substantially the same as structures of the first light source 821 and the first light source circuit board 811 described above, respectively.

When the second light source module 802 includes the plurality of second light sources 822, the plurality of second light sources 822 is disposed below the light guide plate 300. For example, the plurality of second light sources 822 is disposed along the X-axis direction, facing the lower surface 31 of the light guide plate 300.

The light from the second light source 822 is incident to the lower surface 31 of the extension portion 300b. The extension portion 300b diffuses the light incident to the lower surface 31 and guides the light toward the display panel 100.

As illustrated in FIG. 1, when the display device includes the plurality of second light source modules 802, the plurality of second light source modules 802 may be disposed at regular intervals along the Y-axis direction.

The optical film 200 diffuses and collimates the light directed thereto from the light guide plate 300. The optical film 200 is positioned between the light guide plate 300 and the display panel 100. The optical film 200 may include a diffusion film 200a, a light collimation film 200b, and a protection film 200c. The diffusion film 200a, the light collimation film 200b, and the protection film 200c are stacked on the light guide plate 300 in the listed order.

The diffusion film 200a is disposed on the light guide plate 300. The diffusion film 200a serves to diffuse the light guided from the light guide plate 300 so as to substantially prevent or reduce the light from being concentrated to only a part of the light guide plate 300.

The light collimation film 200b is disposed on the diffusion film 200a. The light collimation film 200b collimates the light diffused by the diffusion film 200a in a direction perpendicular to the display panel 100. For example, the light collimation film 200b may include prisms, each having a triangular cross-section, may be disposed in a predetermined arrangement on a surface of the light collimation film 200b.

The protection film 200c is disposed on the light collimation film 200b. The protection film 200c serves to protect a surface of the light collimation film 200b and diffuse light to achieve uniform light distribution. The light transmitted through the protection film 200c is directed to the display panel 100.

In an exemplary embodiment, a double brightness enhancement film may be used in place of the protection film 200c described above.

In another exemplary embodiment, the optical film 200 may include a double brightness enhancement film, a first light collimation film, and a second light collimation film. The double brightness enhancement film, the first light collimation film, and the second light collimation film are sequentially stacked on the light guide plate 300 in the listed order. For example, the double brightness enhancement film is disposed between the light guide plate 300 and the first light collimation film, the first light collimation film is disposed between the double brightness enhancement film and the second light collimation film, and the second collimation film is disposed between the first light collimation film and the display panel 100. Prisms of the first light collimation film and prisms of the second light collimation film may be arranged in different directions from each other. For example, when the prisms of the first light collimation film are arranged along the X-axis direction, the prisms of the second light collimation film may be arranged along the Y-axis direction.

The support frame 400 supports the display panel 100, and also maintains a uniform interval between the display panel 100 and the optical film 200. For example, as illustrated in FIG. 2, the support frame 400 may have a quadrangular frame shape including a first support portion 400a and a second support portion 400b.

The first support portion 400a encloses the side portions 612 of the bottom case 600. The first support portion 400a closely contacts the side portions 612 to prevent or limit the support frame 400 from moving.

The second support portion 400b protrudes from the first support portion 400a toward a space between the optical film 200 and the display panel 100. For example, the second support portion 400b is disposed between an edge of an uppermost film (e.g., the protection film 200c) of the optical film 200 and an edge of the display panel 100.

A foam tape 41 may be disposed between the second support portion 400b and the edge of the display panel 100. The display panel 100 may be attached to the second support portion 400b by the foam tape 41.

The display panel 100 is operable to display images. The display panel 100 is located on the optical film 200. The display panel 100 includes a first substrate 101, a second substrate 102, a first polarizing plate 111, and a second polarizing plate 112. In an exemplary embodiment, the display panel 100 further includes a light control layer disposed between the first substrate 101 and the second substrate 102. The first substrate 101 and the second substrate 102 face each other with the light control layer therebetween.

The light control layer may be any layer as long as it may control the transmittance of the light. For example, the light control layer may be any one of a liquid crystal layer, an electrowetting layer, and an electrophoretic layer. Hereinafter, it will be described on the premise that the light control layer is a liquid crystal layer by way of example.

A plurality of gate lines, a plurality of data lines, and a plurality of pixel electrodes are disposed on the first substrate 101. The data lines cross the gate lines. The gate lines are connected to a gate driver 134, and the data lines are connected to a data driver 136.

The gate driver 134 may be disposed at a non-display area of the first substrate 101. The gate driver 134 generates gate signals according to a gate control signal applied from a timing controller, and sequentially applies the gate signals to the plurality of gate lines. The gate driver 134 may include, for example, a shift register that shifts a gate start pulse based on a gate shift clock to produce the gate signals. The shift register may include a plurality of driving transistors.

The data driver 136 includes a plurality of data driving integrated circuits ("ICs") 147. The data driving ICs 147 receive digital image data signals and a data control signal applied thereto from the timing controller. The data driving ICs 147 sample the digital image data signals according to the data control signal, latch the sampled image data signals corresponding to one horizontal line every horizontal period, and apply the latched image data signal to the data lines. That is, the data driving ICs 147 convert the digital image data signals applied from the timing controller into analog image signals using a gamma voltage applied from a power supplier, and apply the analog image signals to the data lines.

Respective data driving ICs 147 are mounted on carriers 146. The carriers 146 are connected between the PCB 168 and the display panel 100. The driving circuit unit 177 including the timing controller and the power supplier described above may be positioned at the PCB 168, and the carrier 146 includes input wirings configured to transmit various signals applied thereto from the timing controller and the power supplier to the data driving IC 147 and output wirings configured to transmit the image data signals output from the data driving IC 147 to corresponding one of the data lines.

In an exemplary embodiment, at least one carrier 146 may further include auxiliary lines to transmit various signals applied from the timing controller and the power supplier to the gate driver 134, and the auxiliary lines are connected to connection lines located at the first substrate 101. The connection lines connect the auxiliary wirings and the gate driver 134 to each other. The connection lines may be formed on the first substrate 101 in a line-on-glass manner.

The first polarizing plate 111 is disposed on an outer surface of the first substrate 101, and the second polarizing plate 112 is disposed on an outer surface of the second substrate 102. Herein, when facing surfaces of the first substrate 101 and the second substrate 102 are defined as inner surfaces of the corresponding substrates, the respective outer surfaces of the first substrate 101 and the second substrate 102 mean surfaces of the corresponding substrates that are positioned opposite to the inner surfaces, respectively.

An optical axis of the first polarizing plate 111 may intersect an optical axis of the second polarizing plate 112. For example, when the optical axis of the first polarizing plate 111 is parallel to an X-axis direction, the optical axis of the second polarizing plate 112 may be parallel to the Y-axis direction.

The top case 500 covers one side edge portion of the display panel 100, and an upper surface and a side surface of the first support portion 400a of the support frame 400. For example, the top case 500 includes a front cover 533a that covers the side edge portion of the display panel 100 and the upper surface of the first support portion 400a, and a side cover 533b that covers the side surface of the first support portion 400a. As used herein, the side edge portion of the display panel 100 refers to an edge portion of the display panel 100 that is connected to the data driver 136.

The protection case 550 protects the PCB 168 and the driving circuit unit 177 disposed at the PCB 168. The protection case 550 covers the PCB 168 and the driving circuit unit 177.

The protection case 550 includes a first protective portion 550a and a second protective portion 550b.

The first protective portion 550a faces the first base portion 611a. In addition, the first protective portion 550a faces the second base portion 611b with the PCB 168 and the driving circuit unit 177 therebetween. The PCB 168 and the driving circuit unit 177 are disposed between the first protective portion 550a and the second base portion 611b.

The second protective portion 550b protrudes from one side edge of the first protective portion 550a toward the Z-axis direction. The second protective portion 550b faces the support frame 400 with a side cover portion 500b of the top case 500 therebetween. In other words, the side cover portion 500b is disposed between the second protective portion 550b and the support frame 400.

When the upper surface 32 of the light guide plate 300 is defined as a reference surface as described above, a height H1 (or a distance) from the reference surface to an outer surface of the first protective portion 550a and a height H2 (or a distance) from the reference surface to the outer surface of the third based portion 611c are substantially the same. Accordingly, the outer surface of the first protective portion 550a and the outer surface of the third based portion 611c are disposed on substantially the same plane. In other words, the height difference between the outer surface of the first protective portion 550a and the outer surface of the third based portion 611c is substantially zero. In such an exemplary embodiment, the outer surface of the first protective portion 550a refers to a surface of the first protective portion 550a on the opposite side of an inner surface of the first protective portion 550a that faces the light guide plate 30.

Since the outer surface of the first protective portion 550a and the outer surface of the third base portion 611c are disposed on a substantially same plane, the back surface of the display device may maintain a substantially flat state.

FIG. 4 is an enlarged view of a peripheral portion of another exemplary embodiment of the light guide plate 300 of FIG. 2.

The scattering layer 910 may be disposed on the upper surface 32 of the light guide plate 300, as illustrated in FIG. 4. Specifically, the scattering layer 910 may be disposed on the upper surface 32 of the light guide portion 300a and the upper surface 32 of the extension portion 300b. In such an exemplary embodiment, the scattering layer 910 may overlap substantially an entire area of the upper surface 32 of the light guide plate 300.

In addition, the display device according to an exemplary embodiment may further include a colour conversion layer 920 disposed on the scattering layer 910. The colour conversion layer 920 may be disposed between the scattering layer 910 and the optical film 200. The colour conversion layer 920 may be added when each of the first and second light sources 821 and 822 is a light source that emits a blue light.

The colour conversion layer 920 changes a colour of the light provided from the light guide plate 300. For example, the colour conversion layer 920 converts the blue light provided from the first light source 821 and the second light source 822 via the light guide plate 300 into a white light.

The colour conversion layer 920 may include a resin that includes a phosphor (i.e., a fluorescence material). A phosphor is a substance that emits fluorescence when light or radiation is incident thereto, and emits a light having an inherent wavelength of the phosphor. In addition, the phosphor emits light to substantially an entire area regardless of the direction of the light or radiation incident thereto. According to an exemplary embodiment, quantum dots may be used as the phosphor. In such an exemplary embodiment, the quantum dot may have at least one shape of, e.g., a spherical shape, a rod, a pyramid, a multi-arm, a cubic nanoparticle, a nanotube, a nanowire, a nanofiber, and a nanoplate.

The quantum dot absorbs light incident thereto and emits light having a wavelength different from a wavelength of the incident light. That is, the quantum dot is a wavelength converting particle that may convert the wavelength of light incident to the quantum dot. A wavelength range of light a quantum dot may convert may vary depending on the size of the quantum dot. For example, by adjusting the diameter of the quantum dot, the quantum dot may emit light of a desired colour.

In general, the quantum dot has a high extinction coefficient and a high quantum yield, thus emitting significantly intense fluorescence. In particular, the quantum dot may absorb light of a short wavelength and then may emit light of a longer wavelength. The quantum dot may have a full width of half maximum (FWHM) of the emission wavelength spectrum of about 45 nm or less, preferably about 40 nm or less, more preferably about 30 nm or less, and the colour purity or colour reproducibility may be improved in the above range. In addition, since light emitted through the quantum dots is emitted in all directions, a viewing angle may be improved.

The quantum dot may have a structure including a core nanocrystal and a shell nanocrystal surrounding the core nanocrystal. In addition, the quantum dot may include an organic ligand bonded to the shell nanocrystal and may include an organic coating layer surrounding the shell nanocrystal.

The shell nanocrystal may be formed having two or more layers. The shell nanocrystal is placed on the surface of the core nanocrystal. In such an exemplary embodiment, an interface between the core nanocrystal and the shell nanocrystal may have a concentration gradient, that is, the concentration of elements existing in the shell nanocrystal becomes lower toward the center.

The quantum dot may include at least one of: Group II compound semiconductors, Group III compound semiconductors, Group IV compound semiconductors, Group V compound semiconductors, and Group VI compound semiconductors. For example, the quantum dot may be selected from: Group II-VI compounds, Group III-V compounds, Group IV-VI compounds, Group IV elements, Group IV compounds, and combinations thereof.

In specific, the Group II-VI compound may be selected from the group consisting of: a binary compound of CdO, CdS, CdSe, CdTe, ZnO, ZnS, ZnSe, ZnTe, HgS, HgSe, HgTe, MgSe, MgS and mixtures thereof; a ternary compound of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and mixtures thereof; and a quaternary compound of CdZnSeS, CdZnSeTe, CdZnSTe, CdHgSeS, CdHgSeTe, CdHgSTe, HgZnSeS, HgZnSeTe, HgZnSTe, and mixtures thereof. The Group III-V compound may be selected from the group consisting of: a binary compound of GaN, GaP, GaAs, GaSb, AlN, AlP, AlAs, AlSb, InN, InP, InAs, InSb, and mixtures thereof; a ternary compound of GaNP, GaNAs, GaNSb, GaPAs, GaPSb, AlNP, AlNAs, AlNSb, AlPAs, AlPSb, InNP, InNAs, InNSb, InPAs, InPSb, and mixtures thereof; and a quaternary compound of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and mixtures thereof. The Group IV-VI compound may be selected from the group consisting of: a binary compound of SnS, SnSe, SnTe, PbS, PbSe, PbTe, and mixtures thereof; a ternary compound of SnSeS, SnSeTe, SnSTe, PbSeS, PbSeTe, PbSTe, SnPbS, SnPbSe, SnPbTe, and mixtures thereof; and a quaternary compound of SnPbSSe, SnPbSeTe, SnPbSTe, and mixtures thereof. The Group IV element may be selected from the group consisting of Si, Ge, and mixtures thereof. The Group IV compound may be selected from the group consisting of SiC, SiGe, and mixtures thereof.

In such an exemplary embodiment, the binary compound, the ternary compound, or the quaternary compound may be present in the particle at a uniform concentration, or the concentration distributions thereof may be partially different in the same particle.

Even quantum dots of the substantially same composition may produce different lights depending on their diameters. For example, in the case where the core nanocrystal includes CdSe, a blue light may be generated when the diameter of the quantum dot is in a range from about 1 nm to about 3 nm, a green light may be generated when the diameter of the quantum dot is in a range from about 3 nm to about 5 nm, and a red light may be generated when the diameter of the quantum dots is in a range from about 7 nm to about 10 nm.

As the display device according to an exemplary embodiment further includes the colour conversion layer 920 that includes the phosphor, e.g., quantum dots, the colour purity of the display device may be improved and the display quality of the display device may also be improved.

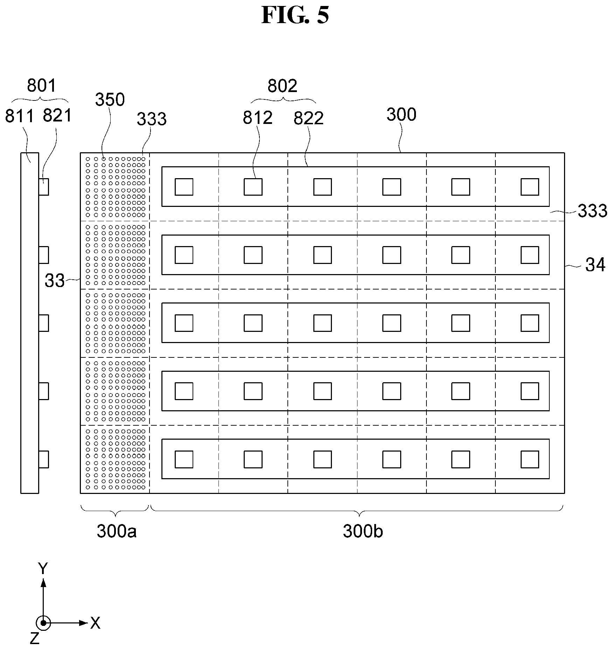

FIG. 5 is a plan view illustrating the light guide plate 300, the first light source module 801, and the second light source module 802 of FIG. 2.

As illustrated in FIG. 5, the light guide plate 300 may include dimming areas 333. The dimming areas 333 may be arranged in a matrix form. In FIG. 5, the light guide plate 300 that includes thirty five dimming areas 333 arranged in a 7×5 matrix is illustrated by way of example.

The dimming areas 333 of the light guide portion 300a is disposed adjacent to the first light sources 821 of the first light source module 801 in the X-axis direction. Luminance of each of the dimming areas 333 of the light guide portion 300a may be individually controlled by the first light sources 821. For example, luminance of each of the first light sources 821 may be individually controlled by a first light source driver. The luminance of each of the first light sources 821 may be controlled according to the luminance of an image corresponding to the dimming areas 333 of the light guide portion 300a. For example, when an area of the display panel 100 corresponding to a dimming area 333 of the light guide portion 300a displays a bright image, the first light source 821 corresponding to the dimming area 333 provides a light of a high luminance. As a contrary example, when the area of the display panel 100 corresponding to the dimming area 333 displays a dark image, the first light source 821 corresponding to the dimming area 333 provides a light of a low luminance.

The dimming areas 333 of the extension portion 300b face the second light sources of the second light source module 802 in the Z-axis direction. Luminance of the dimming areas 333 of the light guide portion 300a may be individually controlled by the second light sources 822. For example, luminance of the second light sources 822 may be individually controlled by a second light source driver. The luminance of the second light sources 822 may be controlled according to the luminance of an image corresponding to the dimming areas 333 of the light guide portion 300a. For example, when an area of the display panel 100 corresponding to a dimming area 333 of the light guide portion 300a displays a bright image, the second light source 822 corresponding to the dimming area 333 provides a light of a high luminance. As a contrary example, when the area of the display panel 100 corresponding to the dimming area 333 displays a dark image, the second light source 822 corresponding to the dimming area 333 provides a light of a low luminance.

FIG. 5 illustrates that one light source is disposed for each dimming area 333, but a plurality of light sources may be disposed for each dimming area 333. In such a case, a plurality of light sources arranged corresponding to one dimming area 333 are controlled to emit lights of a substantially same luminance.

The first light source driver and the second light source driver may be included in the driving circuit unit 177.

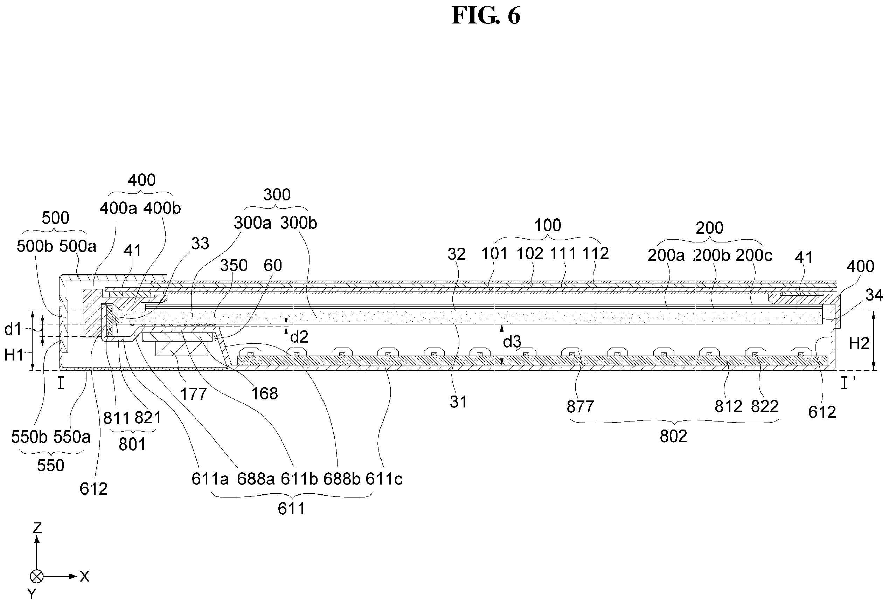

FIG. 6 is a cross-sectional view taken along sectional line I-I' in FIG. 1 according to another exemplary embodiment.

As illustrated in FIG. 6, the second light source module 802 may further include a lens 877. The lens 877 encloses the second light source 822. When the second light source module 802 includes the plurality of second light sources 822, the plurality of lenses 877 individually surround the plurality of second light sources 822, respectively. The lens 822 may have a hemispherical shape. In another exemplary embodiment, the lens 822 may have various shapes, e.g., a parabolic or semi-cylindrical shape, other than the hemispherical shape

In an exemplary embodiment, the first light source module 801 may further include a lens that encloses the first light source 821.

The remaining components of FIG. 6 are substantially the same as those of FIGS. 1 to 5 described above.

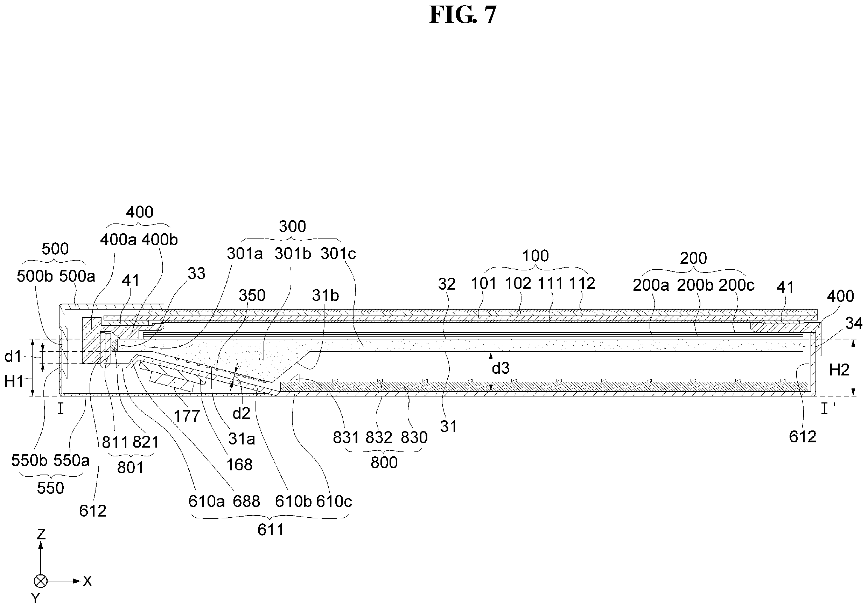

FIG. 7 is a cross-sectional view taken along sectional line I-I' in FIG. 1 according to another exemplary embodiment.

As illustrated in FIG. 7, a display device according to an exemplary embodiment includes a second light source module 800, the bottom case 600, the light guide plate 300, the light guide pattern 350, the optical film 200, the support frame 400, the display panel 100, the PCB 168, the driving circuit unit 177, the protection case 550, and the top case 500.

The light guide plate 300 is positioned inside the bottom case 600. The light guide plate 300 includes a first light guide portion 301a, a second light guide portion 301b, and an extension portion 301c. The extension portion 301c extends from the first light guide portion 301a along the X-axis direction. The first light guide portion 301a, the second light guide portion 301b, and the extension portion 301c are integrally formed into a unitary structure.

A length of the extension portion 301c may be longer than a length of the first light guide portion 301a. As used herein, the length of the extension portion 301c and the length of the first light guide portion 301a each refer to lengths thereof in the X-axis direction.

A thickness of the extension portion 301c may be substantially the same as a thickness of the first light guide portion 301a. In such an exemplary embodiment, the thickness of the extension portion 301c and the thickness of the first light guide portion 301a each refer to thicknesses thereof in the Z-axis direction.

The second light guide portion 301b protrudes from the first light guide portion 301a toward the bottom case 600. As a specific example, the second light guide portion 301b may protrude from the first light guide portion 301a toward a connection portion between a second base portion 610b and a third base portion 610c of the bottom case 600.

The second light guide portion 301b may have a triangular cross-section. In such an exemplary embodiment, the second light guide portion 301b may have a width that gradually decreases along a protruding direction (e.g., a -Z-axis direction). As used herein, the width of the second light guide portion 301b refers to a distance between inclined surfaces 31a and 31b that face each other, that is, a distance in the X-axis direction.

One inclined surface (hereinafter, "a first inclined surface") 31a of the inclined surfaces 31a and 31b of the second light guide portion 301b faces the bottom case 600, and the other inclined surface (hereinafter, "a second inclined surface") 31b thereof faces a first dimming light source 831. A length of the first inclined surface 31a is longer than a length of the second inclined surface 31b. As another exemplary embodiment, the length of the first inclined surface 31a and the length of the second inclined surface 31b may be substantially the same as each other. As another exemplary embodiment, the length of the first inclined surface 31a may be less than the length of the second inclined surface 31b.

Two of surfaces of the light guide plate 300 that face each other in the Z-axis direction are defined as the lower surface 31 and the upper surface 32 of the light guide plate 300, and two of surfaces of the light guide plate 300 that face each other in the X-axis direction are defined as the first side surface 33 and the second side surface 34 of the light guide plate 300. The lower surface 31 of the light guide plate 300 is farther away from the display panel 100 than the upper surface 32 thereof is therefrom.

The lower surface 31 of the light guide plate 300 includes the lower surface 31 of the first light guide portion 301a, the first inclined surface 31a of the second light guide portion 301b, the second inclined surface 31b of the second light guide portion 301b, and the lower surface 31 of the extension portion 301c.

The upper surface 32 of the light guide plate 300 includes the upper surface 32 of the first light guide portion 301a and the upper surface 32 of the extension portion 301c.

At least one light guide pattern 350 is disposed at the second light guide portion 301b. For example, the plurality of light guide patterns 350 are disposed on the first inclined surface 31a of the second light guide portion 301b. The plurality of light guide patterns 350 may be disposed on the first inclined surface 31a along the X-axis direction and the Y-axis direction.

The pitch (or interval spacing) of the light guide patterns 350 arranged in the X-axis direction may gradually decreases along a direction (e.g., a -X-axis direction) farther away from the first dimming light source 831. In another exemplary embodiment, however, the light guide patterns 350 may be arranged at regular intervals. The light guide patterns 350 are disposed between the second base portion 610b of the bottom case 600 and the first inclined surface 31a of the light guide plate 300.

An angle θ between the second inclined surface 31b of the second light guide portion 301b and the lower surface 31 of the extension portion 301c may be an obtuse angle.

The bottom case 600 has an open space therein. The second light source module 800, the light guide plate 300, and the optical film 200 are disposed in the open space.

In order to form the open space, the bottom case 600 may include the housing portion 611 and the plurality of side portions 612. For example, the housing portion 611 may have a quadrangular shape, and the side portions 612 protrude from respective edges of the housing portion 611 to have a predetermined height. For example, the side portions 612 may protrude from the respective edges of the housing portion 611 along the Z-axis direction. For example, each of the side portions 612 may protrude from the edges of the housing portion 611 toward the top case 500. The housing portion 611 and the side portions 612 may be integrally formed into a unitary structure. Edges of adjacent ones of the side portions 612 may be connected to each other.

Two side portions facing each other (e.g., side portions 612 facing each other in the X-axis direction in FIG. 7) may have lengths different from each other. For example, a side portion (hereinafter, "a first side portion") of the two facing side portions 612 that is closer to the first light guide portion 301a of the light guide plate 300 may have a length shorter than a length of the other side portion (hereinafter, "a second side portion") of the two facing side portions 612. As used herein, the respective lengths of the first and second side portions refer to lengths thereof in the Z-axis direction.

The housing portion 611 of the bottom case 600 includes a first base portion 610a, a connection portion 688, a second base portion 610b, and a third base portion 610c. The first side portion protrudes from an edge of the first base portion 610a, and the second side portion protrudes from an edge of the third base portion 610c.

The first base portion 610a faces the first light guide portion 301a.

The second base portion 610b faces the first inclined surface 31a of the second light guide portion 301b. The second base portion 610b has a shape inclined so as to be parallel to the first inclined surface 31a.

The first dimming light source 831 has a light emission surface facing the second inclined surface 31b of the second light guide portion 301b. The light emission surface of the first dimming light source 831 has a shape inclined so as to be parallel to the second inclined surface 31b.

The connection portion 688 connects the first base portion 610a and the second base portion 610b. The second base portion 610b may have an inclined shape.

The first base portion 610a, the second base portion 610b, and the third base portion 610c are located at different distances from the light guide plate 300. For example, when a distance between the lower surface 31 of the first light guide portion 301a and the first base portion 610a is defined as a first distance d1, a distance between the first inclined surface 31a of the second light guide portion 301b and the second base portion 610b is defined as a second distance d2, and a distance between the lower surface 31 of the extension portion 301c and the third base portion 610c is defined as a third distance d3, the first, second, and third distances are different from each other. In specific, the first distance d1 is greater than the second distance d2 and less than the third distance d3 (d2<d1<d3).

The second light source module 800 is disposed between the bottom case 600 and the light guide plate 300. The second light source module 800 is disposed on the third base portion 610c of the housing portion 611 of the bottom case 600.

The second light source module 800 includes at least one first dimming light source 831, at least one second dimming light source 832, and a dimming light source circuit board 830.

The first dimming light source 831 may emit the white or blue light. The first dimming light source 831 is disposed between the second light guide portion 301b of the light guide plate 300 and the third base portion 610c of the bottom case 600. The first dimming light source 831 has a light emission surface facing the second inclined surface 31b of the second light guide portion 301b. The light emission surface of the first dimming light source 831 has a shape inclined so as to be substantially parallel to the second inclined surface 31b.

The second dimming light source 832 may emit the white or blue light. The second dimming light source 832 is disposed between the extension portion 301c of the light guide plate 300 and the third base portion 610c of the bottom case 600. The second dimming light source 832 has a light emission surface facing the extension portion 301c. The light emission surface of the second dimming light source 832 is parallel to the lower surface 31 of the extension portion 301c.

For example, luminance of each of the dimming areas 333 of the light guide portion 300a may be individually controlled by the first light sources 821 and the first dimming light source 831. For example, luminance of each of the first light sources 821 may be individually controlled by the first light source driver and the first dimming light source 831 may be individually controlled by the dimming light source circuit board 830. The luminance of each of the first light sources 821 may be controlled according to the luminance of an image corresponding to the dimming areas 333 of the light guide portion 300a. For example, when an area of the display panel 100 corresponding to a dimming area 333 of the light guide portion 300a displays a bright image, the first light source 821 and the first dimming light source 831 corresponding to the dimming area 333 provide a light of a high luminance. As a contrary example, when the area of the display panel 100 corresponding to the dimming area 333 displays a dark image, the first light source 821 and the first dimming light source 831 corresponding to the dimming area 333 provide a light of a low luminance.

The remaining components of FIG. 7 are substantially the same as those of FIGS. 1, 2, 3, 4, 5, and 6 described above.

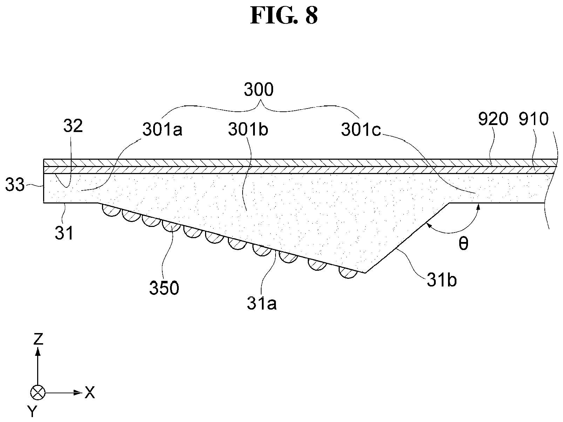

FIG. 8 is an enlarged view of a peripheral portion of an exemplary embodiment of the light guide plate 300 of FIG. 7.

The scattering layer 910 may be disposed on the upper surface 32 of the light guide plate 300, as illustrated in FIG. 8. More specifically, the scattering layer 910 may be disposed on the upper surface 32 of the first light guide portion 301a, the upper surface 32 of the second light guide portion 301b, and the upper surface 32 of the extension portion 301c. In such an exemplary embodiment, the scattering layer 910 may overlap substantially an entire area of the upper surface 32 of the light guide plate 300.

In another exemplary embodiment, the scattering layer 910 may be selectively disposed only on the upper surface 32 of the extension portion 301c.

In addition, the colour conversion layer 920 may be disposed between the scattering layer 910 and the optical film 200. The colour conversion layer 920 may be added when each of the first dimming light source 831 and the second dimming light source 832 is a light source that emits a blue light.

The colour conversion layer 920 changes the colour of the light provided from the light guide plate 300. For example, the colour conversion layer 920 converts the blue light provided from the first dimming light source 831 and the second dimming light source 832 via the light guide plate 300 into a white light.

The colour conversion layer 920 may include a resin that includes a phosphor.

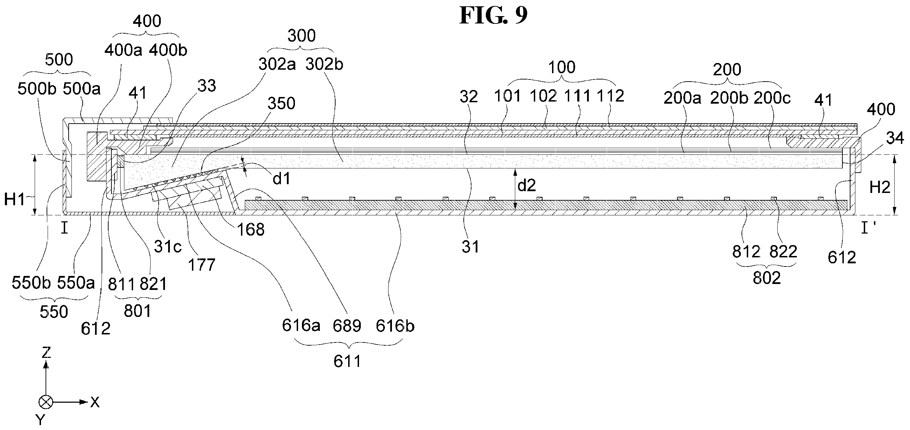

FIG. 9 is a cross-sectional view taken along sectional line I-I' in FIG. 1 according to another exemplary embodiment.

As illustrated in FIG. 9, a display device according to an exemplary embodiment includes the first light source module 801, the second light source module 802, the bottom case 600, the light guide plate 300, the light guide pattern 350, the optical film 200, the support frame 400, the display panel 100, the PCB 168, the driving circuit unit 177, the protection case 550, and the top case 500.

The light guide plate 300 is positioned inside the bottom case 600. The light guide plate 300 includes a light guide portion 302a and an extension portion 302b. The extension portion 302b extends from the light guide portion 302a along the X-axis direction. The light guide portion 302a and the extension portion 302b are integrally formed into a unitary structure.

A length of the extension portion 302b may be longer than a length of the light guide portion 302a. As used herein, the length of the extension portion 302b and the length of the light guide portion 302a each refer to lengths thereof in the X-axis directions.

The light guide portion 302a may have a trapezoidal cross-section. The light guide portion 302a has a thickness gradually decreasing along the X-axis direction. In such an exemplary embodiment, a portion of the light guide portion 302a that is closest to the first light source module 801 has a greatest thickness, and a portion thereof that is farthest from the first light source module 801 has a smallest thickness. A minimum thickness of the light guide portion 302a is substantially equal to a thickness of the extension portion 302b. As used herein, the thickness refers to a size thereof in the Z-axis direction.

An inclined surface 31c of the light guide portion 302a faces the bottom case 600.

Two of surfaces of the light guide plate 300 that face each other in the Z-axis direction are defined as the lower surface 31 and the upper surface 32 of the light guide plate 300, and two of surfaces of the light guide plate 300 that face each other in the X-axis direction are defined as the first side surface 33 and the second side surface 34 of the light guide plate 300. The lower surface 31 of the light guide plate 300 is farther away from the display panel 100 than the upper surface 32 thereof is therefrom. The lower surface 31 of the light guide plate 300 includes the inclined surface 31c of the light guide portion 302a and the lower surface 31 of the extension portion 302b.

The upper surface 32 of the light guide plate 300 includes the upper surface 32 of the light guide portion 302a and the upper surface 32 of the extension portion 302b.

At least one light guide pattern 350 is disposed at the light guide portion 302a. For example, the plurality of light guide patterns 350 are disposed at the inclined surface 31c of the light guide portion 302a. As a specific example, the light guide patterns 350 are disposed between a first base portion 616a of the bottom case 600 and the inclined surface 31c of the light guide plate 300. The light guide patterns 350 are arranged in the X-axis direction and the Y-axis direction.

The pitch (or interval spacing) of the light guide patterns 350 arranged in the X-axis direction may gradually decrease along a direction (e.g., the X-axis direction) farther away from the first light source module 801 (or the first light source 821 of the first light source module 801). In another exemplary embodiment, however, the light guide patterns 350 may be arranged at regular intervals.

An angle θ between the inclined surface 31c of the light guide portion 302a and the lower surface 31 of the extension portion 302b may be an obtuse angle.

The bottom case 600 has an open space therein. The first light source module 801, the second light source module 802, the light guide plate 300, and the optical film 200 are disposed in the open space.

In order to form the open space, the bottom case 600 may include the housing portion 611 and the plurality of side portions 612. For example, the housing portion 611 may have a quadrangular shape, and the side portions 612 protrude from respective edges of the housing portion 611 to have a predetermined height. For example, the side portions 612 may protrude from the respective edges of the housing portion 611 along the Z-axis direction. As a specific example, each of the side portions 612 may protrude from the edges of the housing portion 611 toward the top case 500. The housing portion 611 and the side portions 612 may be integrally formed into a unitary structure. Edges of adjacent ones of the side portions 612 may be connected to each other.

Two side portions facing each other with the first light source module 801 therebetween (e.g., side portions 612 facing each other in the X-axis direction in FIG. 9) may have lengths different from each other. For example, a side portion (hereinafter, "a first side portion") of the two facing side portions 612 that is closer to the light guide portion 302a of the light guide plate 300 may have a length shorter than a length of the other side portion (hereinafter, "a second side portion") of the two facing side portions 612. As used herein, the respective lengths of the first and second side portions refer to lengths thereof in the Z-axis direction.

As illustrated in FIG. 8, the housing portion 611 of the bottom case 600 may include a first base portion 616a, a connection portion 689, and a second base portion 616b. The first side portion protrudes from an edge of the first base portion 616a, and the second side portion protrudes from an edge of the second base portion 616b.

The first base portion 616a faces the inclined surface 31c of the light guide portion 302a. The first base portion 616a has a shape inclined so as to be parallel to the inclined surface 31c.

The second base portion 616b faces the extension portion 302b.

The connection portion 689 connects the first base portion 616a and the second base portion 616b. The connection portion 689 may have an inclined shape.

The first base portion 616a and the third base portion 616b are located at different distances from the light guide plate 300. For example, when a distance between the inclined surface 31c of the light guide portion 302a and the first base portion 616a is defined as a first distance d1, and a distance between the lower surface 31 of the extension portion 302b and the second base portion 616b is defined as a second distance d2, the first and second distances are different from each other. In specific, the first distance d1 is less than the second distance d2 (d1<d2).

The first light source module 801 is positioned between the first side surface of the bottom case 600 and the light guide portion 302a. The first light source module 801 is substantially the same as the first light source module 801 of FIGS. 1, 2, 3, 4, 5, and 6 described above.

The second light source module 802 is positioned between the second base portion 616b of the bottom case 600 and the extension portion 302b. The second light source module 802 is substantially the same as the second light source module 802 of FIGS. 1, 2, 3, 4, 5, and 6 described above.

The remaining components of FIG. 9 are substantially the same as those of FIGS. 1, 2, 3, 4, 5, and 6 described above.

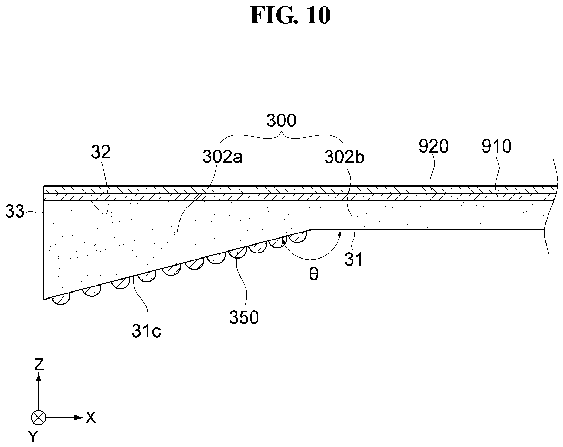

FIG. 10 is an enlarged view of a peripheral portion of an exemplary embodiment of the light guide plate 300 of FIG. 9.

As illustrated in FIG. 10, the scattering layer 910 may be disposed on the upper surface 32 of the light guide plate 300. Specifically, the scattering layer 910 may be disposed on the upper surface 32 of the light guide portion 302a and the upper surface 32 of the extension portion 302b. In such an exemplary embodiment, the scattering layer 910 may overlap substantially an entire area of the upper surface 32 of the light guide plate 300.

Alternatively, in another exemplary embodiment, the scattering layer 910 may be selectively disposed only on the upper surface 32 of the extension portion 302b.

In addition, the colour conversion layer 920 may be disposed between the scattering layer 910 and the optical film 200. The colour conversion layer 920 may be added when each of the first and second light sources 821 and 822 is a light source that emits a blue light

The colour conversion layer 920 changes a colour of the light provided from the light guide plate 300. For example, the colour conversion layer 920 converts the blue light provided from the first light source 821 and the second light source 822 via the light guide plate 300 into a white light.

The colour conversion layer 920 may include a resin that includes a phosphor (i.e., a fluorescence material).

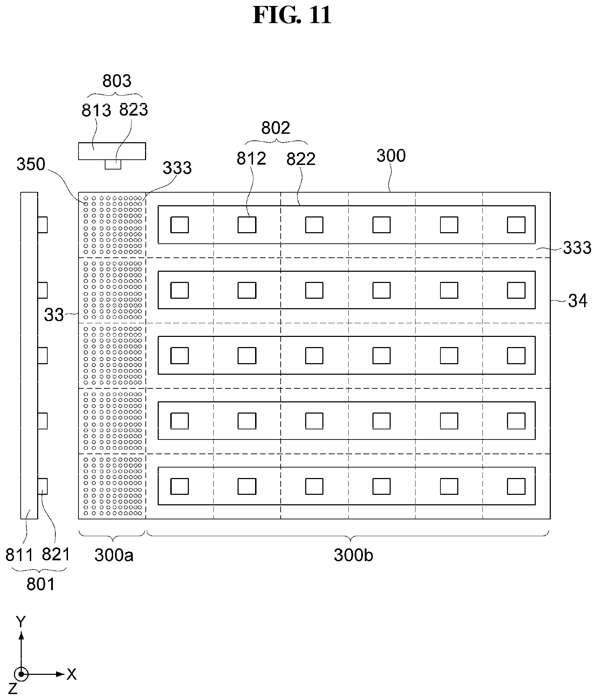

FIG. 11 is a plan view illustrating the light guide plate 300, the first light source module 801, and the second light source module 802 of FIG. 2 according to another exemplary embodiment.

As illustrated in FIG. 11, the light guide plate 300 may include dimming areas 333. These dimming areas 333 are substantially the same as the dimming areas 333 of FIG. 5 described above.

As illustrated in FIG. 11, the display device according to an exemplary embodiment may further include a third light source module 803. The third light source module 803 includes a third light source 823 and a third light source circuit board 813.

The third light source module 803 faces the light guide portion 300a of the light guide plate 300. For example, the third light source module 803 faces the light guide portion 300a in the Y-axis direction. That is, the third light source module 803 faces the light guide portion 300a in the Y-axis direction that intersects the X-axis direction.

The third light source 823 may have a configuration substantially the same as that of the first light source 821 described above. The third light source 823 may emit a blue light or a white light.

A luminance of the third light source 823 may be controlled by a third light source driver. A light from the third light source 823 is provided to the light guide portion 300a. The luminance at the light guide portion 300a may increase by the light from the third light source 823.

The third light source driver may be included in the driving circuit unit 177 described above.

Meanwhile, the lens 877 of FIG. 6 may be added to all the exemplary embodiments described above. In addition, the third light source module 803 of FIG. 11 may be added to all the exemplary embodiments described above.

As set forth hereinabove, a display device according to one or more exemplary embodiments may achieve the following advantageous effects.

First, since light is provided to a display panel through a first light source located at a side surface of a light guide plate and a second light source below the light guide plate, the generated light may have a high or improved luminance.

Second, since light guide patterns are selectively disposed only at a light guide portion of the light guide plate, the light from the first light source hardly affects the light from the second light source that passes through an extension portion. Accordingly, it is possible to individually adjust luminance of a dimming area of the light guide portion and a dimming area of the extension portion. In other words, the display device according to an exemplary embodiment has a structure advantageous for selective, local dimming.

Third, since an outer surface of a protection case and an outer surface of a bottom case are disposed on a substantially same plane, a back surface of the display device may be substantially flat.

Although certain exemplary embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A backlight unit for a display panel comprising:
a light guide plate (300) having opposite upper and lower surfaces, the light guide plate comprising:
a first portion (300a); and
a second portion (300b) extending from the first portion (300a) along a first direction;
light guide patterns (350) disposed on the lower surface (31);
a first light source (821) facing a side surface (33) of the first portion (300a) in the first direction; and
a second light source (822) facing the lower surface (31) in a second direction intersecting the first direction.

2. The backlight unit of claim 1, further comprising:
a scattering layer (910) disposed on an upper surface of at least a part of the second portion.

3. The backlight unit of claim 1 or 2, further comprising a colour conversion layer (920) disposed on an upper surface of at least a part of the second portion.

4. The backlight unit of any one of the preceding claims, wherein the spacing between the light guide patterns gradually decreases with increasing distance from the first light source (821) in the first direction.

5. The backlight unit of any one of the preceding claims, further comprising a bottom case (600) housing the light guide plate, the first light source, and the second light source.

6. The backlight unit of claim 5, wherein the bottom case comprises:
a first base portion facing a lower surface of the first portion with the light guide patterns interposed therebetween;
a second base portion facing the lower surface of the first portion with the light guide patterns interposed therebetween, the second base portion disposed closer to the light guide plate than the first base portion; and
a third base portion facing a lower surface of the second portion with the second light source interposed therebetween, the third base portion disposed farther away from the light guide plate than the first base portion is therefrom, optionally wherein the bottom case comprises:
a first connection portion connecting the first base portion and the second base portion; and
a second connection portion connecting the second base portion and the third base portion.

7. The backlight unit of claim 6, wherein the second base portion has a recess depressed toward the first portion, optionally further comprising a printed circuit board disposed at the recess and connected to the display panel.

8. The backlight unit of claim 6 or 7, further comprising a protection case comprising a protective portion that faces the second base portion with the printed circuit board interposed therebetween.

9. The backlight unit of claim 8, wherein a distance from an upper surface of the light guide plate to an outer surface of the third base portion is substantially equal to a distance from the upper surface of the light guide plate to an outer surface of the protective portion.

10. The backlight unit of any one of the preceding claims, further comprising a lens enclosing the second light source.

11. The backlight unit of any one of the preceding claims, further comprising a third light source facing another side surface of the first portion in a third direction, the third direction intersecting the first direction and the second direction.

12. The backlight unit of claim 1, wherein the first portion comprises a light guide portion and the second portion comprises an extension portion, the light guide portion comprising:
a first light guide portion; and
a second light guide portion extending from the first light guide portion along the first direction,
wherein the second light guide portion comprises: a first inclined surface and a second inclined surface inclined at respective angles in the second direction to form a triangular cross-section,
wherein the light guide patterns are disposed on the first inclined surface of the second light guide portion.

13. The backlight unit of claim 12, wherein the second light source comprises:
a first dimming light source comprising a light emission surface facing the second inclined surface; and
a second dimming light source comprising a light emission surface facing the lower surface corresponding to the extension portion.

14. The backlight unit of claim 13, wherein the light guide patterns are disposed on the lower surface corresponding to the first inclined surface, and
wherein pitch between the light guide patterns gradually decreases along a direction farther away from the first dimming light source.

15. The backlight unit of claim 12, 13 or 14, further comprising a bottom case comprising:
a first base portion facing a lower surface of the first light guide portion;
a second base portion facing the first inclined surface of the second light guide portion with the light guide patterns interposed therebetween; and
a third base portion facing the lower surface of the extension portion with the second light source interposed therebetween,
wherein the light guide plate, the first light source, and the second light source are housed in the bottom case.

16. The backlight unit of any one of claims 12 to 15, wherein the angle between the second inclined surface and the lower surface of the extension portion is an obtuse angle.

17. The backlight unit of claim 1, wherein the first portion comprises a light guide portion and the second portion comprises an extension portion,
wherein a thickness of the light guide portion gradually decreases along a direction farther away from the first light source to form an inclined surface, and
wherein the light guide patterns are disposed on the inclined surface.

18. The backlight unit of claim 17, further comprising a bottom case comprising:
a first base portion facing the inclined surface of the first portion with the light guide patterns interposed therebetween; and
a second base portion facing a lower surface of the second portion with the second light source interposed therebetween,
wherein the light guide plate, the first light source, and the second light source are disposed on the bottom case.

19. The backlight unit of any one of the preceding claims, wherein the light guide plate comprises dimming areas, and
wherein the backlight unit is configured to:
control the first light source to individually adjust the luminance of the dimming areas overlapping the first portion of the light guide plate; and
control the second light source to individually adjust the luminance of the dimming areas overlapping the second portion of the light guide plate.

20. A display device comprising:
a display panel (100); and
a backlight unit according to any one of the preceding claims;
wherein the display panel (100) is disposed on the upper surface (32) of the light guide plate (300) of the backlight unit.
